# EUROPEAN PATENT APPLICATION

(11) **EP 0 539 075 A1**
(43) Date of publication of application: **28.04.1993**
(21) Application number: 92309278.7
(22) Date of filing: 12.10.1992
(51) Int. Cl.: H01L 23/498, H01L 21/58

(54) **Semiconductor device**

(30) Priority: 21.10.1991 JP 271629/91
(71) Applicant: NEC CORPORATION, Tokyo (JP)
(72) Inventor: Kato, Kaneyuki, Minato-ku, Tokyo 108-01 (JP)
(74) Representative: Abnett, Richard Charles

(57) **Abstract**

A semiconductor element (11) is placed on the upper surface of a resin substrate (18) through an insulator sheet (16). A plurality of through-holes (20) are formed in two square circumferential rows at a central portion of the upper surface of the resin substrate (18) along the side faces of the resin substrate (18) underneath the bottom surface of the semiconductor element (11). Lead pins (19) for external connection are inserted one by one into the through-holes (20). A plurality of element connection terminals (17) are provided on the upper surface of the resin substrate (18) on the outside of the through-holes and between the through-holes (20) and the resin stopping frame (14) along the side faces of the resin substrate (18). A larger semiconductor element can thereby be accommodated within the same outer profile size.

## Description

### BACKGROUND OF THE INVENTION

The present invention relates to a semiconductor device.

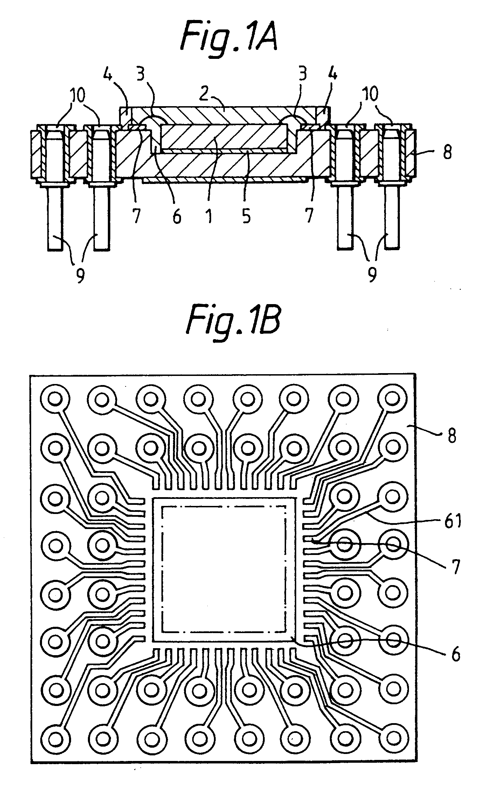

An example of a conventional semiconductor device is shown in FIG. 1A. Referring to FIG. 1A, a semiconductor element 1 is placed in a hole 6 which is formed on the central portion of the upper surface of a resin substrate 8. In order to secure the semiconductor element 1, its bottom surface is adhered to the bottom of the hole 6 by means of a bonding agent 5. Further, in order to protect the semiconductor element 1 from external pressure, the semiconductor element 1 is covered with an enclosure resin 2. A plurality of through-holes 10, each of which extends to the lower face of the resin substrate 8 through the resin substrate 8, are formed in two square circumferential rows along the outer periphery of the upper surface of the resin substrate 8 in such a manner as to surround the hole 6. Lead pins 9 for external connection are inserted one by one in the through-holes 10. A resin stopping frame 4 for preventing the enclosure resin 2 from flowing into the through-holes 10 is provided on the upper surface of the resin substrate 8 between the hole 6 and the lead pins 9 in such a manner as to surround the hole 6. A plurality of element connection terminals 7 are provided on the upper surface of the resin substrate 8 between the hole 6 and the lead pins 9 in such a manner as to surround the hole 6 as shown in FIG. 1B.

Electrical connection between the signal input/output pads (not shown) of the semiconductor element 1 and the lead pins 9 is established by means of a plurality of connecting lines 3 and a plurality of wiring patterns 61. Here, the connecting lines 3 electrically connect the signal input/output pads of the semiconductor element 1 and the element connection terminals 7 one by one to each other. The wiring patterns 61 which are formed on the upper surface of the resin substrate 8 electrically connect the element connection terminals 7 and the lead pins 9 one by one to each other.

The conventional semiconductor device described above, however, has the problem that special specifications are required in order to mount the semiconductor element 1 of a larger size. In particular, with a conventional semiconductor device, since the semiconductor element 1 is placed in the hole 6 which is formed in the central portion of the upper surface of the resin substrate 8, the size of the hole 6 must be increased in order to mount a larger semiconductor element 1. Since the through-holes 10 for receiving the lead pins 9 one by one therein are provided at the circumferential portion of the upper surface of the resin substrate 8, if the outer peripheral edge of the hole 6 comes to the outer side with respect to the positions of the through-holes 10 on the inner circumferential row shown in FIG. 1A, the through-holes 10 on the inner circumferential row must be displaced to positions on the outer side with respect to the through-holes 10 on the outer circumferential row shown in FIG. 1A. As a result, the size of the outer profile of the semiconductor device must be increased. With regard to semiconductor devices of the type mentioned, since the outer profile sizes are standardized according to the number of lead pins for the external connection by the JEDEC (Joint Electron Device Engineering Council) or the EIAJ (Electronic Industries Association of Japan), there is a problem that, when the standardized outer profile sizes cannot be satisfied, special specifications must be employed.

### SUMMARY OF THE INVENTION

An object of the present invention is to provide a semiconductor device which allows mounting of a large semiconductor element while maintaining a standardized outer profile size.

Other objects of the present invention will become obvious from the following description.

In accordance with an aspect of the present invention, there is provided a semiconductor device which comprises: a semiconductor element, a resin substrate having the semiconductor element placed on its upper surface, a plurality of element connection terminals provided on the upper surface of the resin substrate, and a plurality of through-holes formed from the upper surface of the resin substrate, in which the element connection terminals are provided on the outer side with respect to all or some of the through-holes.

### BRIEF DESCRIPTION OF THE DRAWINGS

The features and advantages of the invention will become apparent from the following description when taken in conjunction with the accompanying drawings in which:
FIG. 1A is a side elevational sectional view showing a conventional semiconductor device,
FIG. 1B is a top plan view of the resin substrate shown in FIG. 1A;
FIG. 2A is a side elevational sectional view of a semiconductor device showing the first preferred embodiment of the present invention,
FIG. 2B is a top plan view of the resin substrate shown in FIG. 2A,
FIG. 3A is a side elevational sectional view of another semiconductor device showing the second preferred embodiment of the present invention, and
FIG. 3B is a top plate view of a resin substrate shown in FIG. 3A.

### DESCRIPTION OF THE PREFERRED EMBODIMENTS

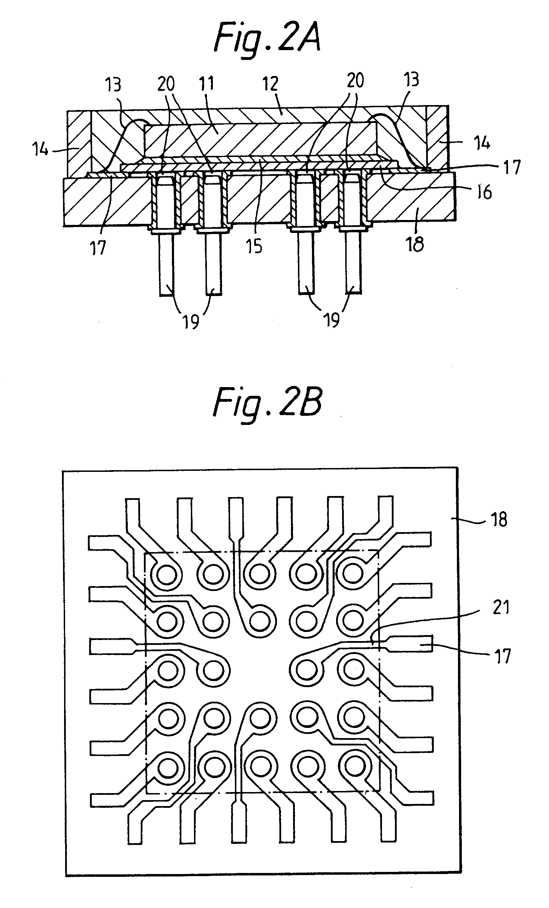

Referring first to FIG. 2A, there is shown a semiconductor device of the first preferred embodiment of the present invention. A semiconductor element 11 having a plurality of signal input/output pads (not shown) is placed on an insulator sheet 16 which is provided between the bottom surface of the semiconductor element 11 and the upper surface of a resin substrate 18. In order to secure the semiconductor element 11, the bottom surface of the element is adhered to the insulator sheet 16 by means of a bonding agent 15. Further, in order to protect the semiconductor element 11 from external pressure, the semiconductor element 11 is covered with an enclosure resin 12.

A plurality of through-holes 20, each of which extends to the lower surface of the resin substrate 18 through the resin substrate 18, are formed in two square circumferential rows in the central portion of the upper surface of the resin substrate 18 along the side faces of the resin substrate 18 in an opposing relationship to (i.e. underneath) the bottom surface of the semiconductor element 11. Lead pins 19 for external connection are inserted one by one into the through-holes 20. A resin stopping frame 14 for preventing the enclosure resin 12 from flowing out of position is provided at the ends of the upper surface of the resin substrate 18 along the side faces of the resin substrate 18. A plurality of element connection terminals 17 are provided on the upper surface of the resin substrate 18 on the outside of the through-holes and between the through-holes 20 and the resin stopping frame 14 along the side faces of the resin substrate 18 as shown in FIG. 2B.

Electric connection between the signal input/output pads of the semiconductor element 11 and the lead pins 19 is established by means of a plurality of connecting lines 13 and a plurality of wiring patterns 21. Here, the connecting lines 13 electrically connect the signal input/output pads and the element connection terminals 17 one by one to each other. The wiring patterns 21 which are formed on the upper surface of the resin substrate 18 electrically connect the element connection terminals 17 and the lead pins 19 one by one to each other. The resin substrate 18 may be formed from a laminate of glass epoxy, glass triazine, or glass polyimide. Copper is provided on the upper and lower surfaces of the resin substrate 18, and the wiring patterns 21 are formed by etching the copper. Each through-hole 20 is plated with copper so that the copper on the upper surface of the resin substrate 18 and the copper on the lower surface of the resin substrate are electrically connected to each other by way of the plated copper of the through-hole 20. Each lead pin 19 is formed from phosphor bronze, covar, or 42-alloy (iron alloy containing 42 % of nickel) with solder plating applied to the surface of the pin.

With the above-described construction of the first embodiment of the semiconductor device according to the present invention, a semiconductor element 11 may be mounted even if the element is of somewhat larger outer profile size by suitably changing the positions at which the element connection terminals 17 are formed on the semiconductor device while maintaining its outer profile size as specified by existing standards.

It is to be noted that, while the semiconductor device of the present embodiment has through-holes 20 formed in two circumferential rows along the side faces of the resin substrate 18, the through-holes 20 may also be formed in any other suitable number of rows and need not necessarily be formed along the side faces of the resin substrate 18.

Referring now to FIG. 3A, there is shown a semiconductor device of the second preferred embodiment of the present invention. A semiconductor element 31 having a plurality of signal input/output pads (not shown) is placed on an insulator sheet 36 which is provided between the bottom surface of the semiconductor element 31 and the upper surface of a resin substrate 38. In order to secure the semiconductor element 31, the bottom surface of the semiconductor element 31 is adhered to the insulator sheet 36 by means of a bonding agent 35. Further, in order to protect the semiconductor element 31 from external pressure, the semiconductor element 31 is covered with an enclosure resin 32.

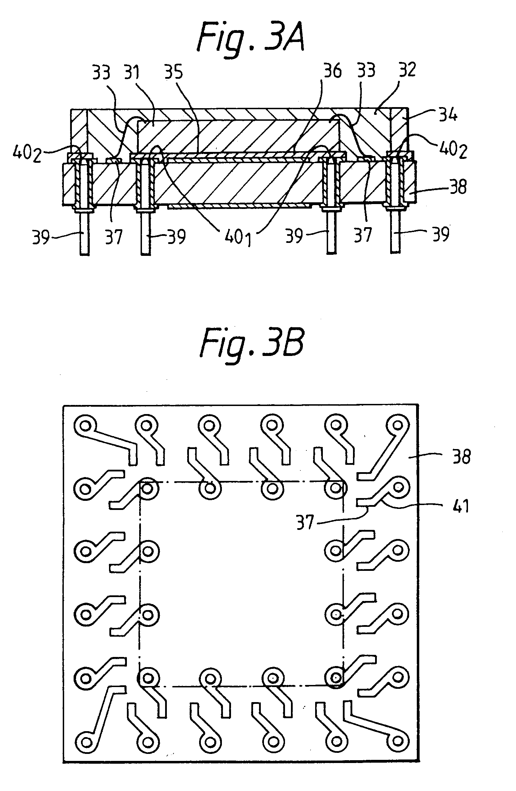

A plurality of first through-holes 40₁, each of which extends to the lower surface of the resin substrate 38 through the resin substrate 38, are formed in a single square circumferential row in the central portion of the upper surface of the resin substrate 38 along the side faces of the resin substrate 38 in an opposing relationship to the bottom surface of the semiconductor element 31. A plurality of second through-holes 40₂, each of which extends to the lower surface of the resin substrate 38 through the resin substrate 38, are formed in a single square circumferential row at the outer peripheral portion of the upper surface of the resin substrate 38 along the side faces of the resin substrate 38. Lead pins 39 for external connection are inserted one by one into the first and second through-holes 40₁ and 40₂. A resin stopping frame 34 for preventing the enclosure resin 32 from flowing out of position is provided at the ends of the upper surface of the resin substrate 38 along the side faces of the resin substrate 38. A plurality of element connection terminals 37 are provided on the upper surface of the resin substrate 38 between the first through-holes 40₁ and the second through-holes 40₂ along the side faces of the resin substrate 38 as shown in FIG. 3B.

Electric connection between the signal input/output pads of the semiconductor element 31 and the lead pins 39 is established by means of a plurality of connecting lines 33 and a plurality of wiring patterns 41. Here, the connecting lines 33 electrically connect the signal input/output pads and element connection terminals 37 one by one to each other. The wiring patterns 41 which are formed on the upper surface of the resin substrate 38 electrically connect the element connection terminals 37 and the lead pins 39 one by one to each other.

With the above-described construction of the second embodiment of the semiconductor device according to the present invention, a semiconductor element 31 of somewhat larger outer profile size can still be mounted by suitably changing the positions at which the element connection terminals 37 are formed on the semiconductor device while maintaining its outer profile size as specified by existing standards.

It is to be noted that, while the semiconductor device of the present embodiment has the first through-holes 40₁ formed in a single circumferential row along the side faces of the resin substrate 38 and the second through-holes 40₂ formed in a single circumferential row along the side faces of the resin substrate 38, the first and second through-holes 40₁ and 40₂ may also be formed in any other suitable number of rows and need not necessarily be formed along the side faces of the resin substrate 38.

While this invention has been described in conjunction with the above preferred embodiments, it would now be possible for any person skilled in the art to readily put this invention into practice in various other ways.

## Claims

1. A semiconductor device comprising:
a semiconductor element (11),
a resin substrate (18) having the semiconductor element placed on the upper surface thereof,
a plurality of element connection terminals (17) provided on the upper surface of the resin substrate, and
a plurality of through-holes (20) formed from the upper surface of the resin substrate;
characterized in that the element connection terminals (17) are provided on the outer side with respect to all or some of the through-holes (20).

2. A semiconductor device as claimed in claim 1, wherein all or some of the through-holes (20) are formed on the upper surface of the resin substrate in an opposing relationship to the bottom surface of the semiconductor element (11).

3. A semiconductor device as claimed in claim 1 or 2, further comprising an insulator sheet (16) between the bottom surface of the semiconductor element (20) and the upper surface of the resin substrate (18) and to which the bottom surface of the semiconductor element is adhered.

4. A semiconductor device comprising
a semiconductor element (11) having a plurality of signal input/output pads,
a resin substrate (18) having the semiconductor element placed on the upper surface thereof,
a plurality of through-holes (20) formed at a central portion of the upper surface of the resin substrate,
a plurality of lead pins (19) for external connection inserted one by one into the through-holes,
a plurality of element connection terminals (17) provided on the upper surface of the resin substrate,
a plurality of connecting wires (13) for electrically connecting the signal input/output pads and the element connection terminals one by one to each other, and
a plurality of wiring patterns (21) formed on the upper surface of the resin substrate for electrically connecting the element connection terminals and the lead pins for external connection one by one to each other,
characterized in that the plurality of element connection terminals (17) are on the outer side with respect to the through-holes (20).

5. A semiconductor device as claimed in claim 4, wherein all of the through-holes (20) are provided on the upper surface of the resin substrate in an opposing relationship to the bottom surface of the semiconductor element (11).

6. A semiconductor device as claimed in claim 4 or 5, further comprising an insulator sheet between the bottom surface of the semiconductor element (20) and the upper surface of the resin substrate (18) and to which the bottom surface of the semiconductor element is adhered.

7. A semiconductor device, comprising:
a semiconductor element (31) having a plurality of signal input/output pads,
a resin substrate (38) having the semiconductor element placed on the upper surface thereof,
a plurality of through-holes (40₁, 40₂) formed from the upper surface of the resin substrate,
a plurality of lead pins (39) for external connection inserted one by one into the first and second through-holes,
a plurality of element connection terminals (37) provided on the upper surface of the resin substrate,
a plurality of connecting wires (33) for electrically connecting the signal input/output pads and the element connection terminals one by one to each other, and
a plurality of wiring patterns (41) formed on the upper surface of the resin substrate for electrically connecting the element connection terminals and the lead pins for the external connection one by one to each other,
characterized in that the plurality of through-holes comprises a plurality of first through-holes (40₁) formed at a central portion of the upper surface of the resin substrate, and a plurality of second through-holes (40₂) formed at a peripheral portion of the upper surface of the resin substrate, and in that the element connection terminals (37) are provided between the first through-holes and the second through-holes.

8. A semiconductor device as claimed in claim 7, wherein all of the first through-holes (40₁) are provided on the upper surface of the resin substrate in an opposing relationship to the bottom surface of the semiconductor element.

9. A semiconductor device as claimed in claim 7 or 8, further comprising an insulator sheet (36) which is provided between the bottom surface of the semiconductor element and the upper surface of the resin substrate and to which the bottom surface of the semiconductor element is adhered.
